# EUROPÄISCHE PATENTSCHRIFT

(11) **EP 2 227 078 B1**
(45) Veröffentlichungstag und Bekanntmachung des Hinweises auf die Patenterteilung: **02.11.2011**
(21) Anmeldenummer: 09154274.6
(22) Anmeldetag: 04.03.2009
(51) Int. Cl.: H05K 7/20, H01L 23/40

(54) **Klemmbauteil zum Andrücken von Leistungs-Bauelementen an einer Kühlfläche**
Clamp component for pressing high performance components to a cooling surface
Composant de serrage destiné à serrer des éléments de performance sur une surface de refroidissement

(43) Veröffentlichungstag der Anmeldung: 08.09.2010
(73) Patentinhaber: ebm-papst Mulfingen GmbH & Co. KG, 74673 Mulfingen (DE)
(72) Erfinder: Best, Dieter, 74653, Ingelfingen (DE); Heinze, Mark, 74585, Rot am See (DE); Fiedler, Erich, 91616, Neusitz (DE); Egner, Thilo, 74653, Ingelfingen-Stachenhausen (DE)
(74) Vertreter: Patentanwälte Dr. Solf & Zapf

(56) Entgegenhaltungen:
- DE-A1-102006 018 716
- DE-C1- 10 052 191
- FR-A3- 2 654 156
- US-A- 5 225 965
- US-A- 5 461 542

## Beschreibung

Die vorliegende Erfindung betrifft ein Klemmbauteil zum Andrücken von Leistungs-Bauelementen, insbesondere Halbleitern, wie z. B. Transistoren, Dioden, Widerständen, an eine Kühlfläche eines Kühlflansches eines Gehäuses, insbesondere zur Aufnahme einer Elektronikschaltung.

Derartige Klemmbauteile sind z.B. aus US 5 225 965 oder aus FR 2 654 156 bekannt und sind z. B. aus als Blattfedern ausgebildeten Andruckelementen gebildet. Da hohe Andruckkräfte erforderlich sind, um eine gute Wärmeübertragung zwischen dem Leistungs-Halbleiter und der Kühlfläche zu gewährleisten, gestaltet sich die Montage des Andruckelementes auf dem Halbleiter auf Grund des hierfür notwendigen Hochbiegens des Blattfederelementes schwierig. Gleichzeitig wird hierdurch auch die mögliche Federkraft begrenzt. Zudem besteht die Gefahr, dass bei dem Montagevorgang des Klemmelementes eine zu hohe Belastung der Lötstelle zwischen dem Leistungs-Halbleiter und der die elektronische Schaltung tragenden Platine erfolgt.

Zudem ist es bekannt, den Leistungs-Halbleiter an dem Kühlkörper festzuschrauben. Hierzu weisen bekannte Leistungs-Halbleiter mittige Durchtrittsöffnungen auf, durch die Schrauben senkrecht zur Halbleiter-Oberfläche verlaufend in den Kühlkörper angeschraubt werden. Auf Grund eines in vielen Einsatzfällen sehr begrenzten Einbauraumes kann aber eine derartige Befestigung oftmals nicht vorgenommen werden.

Der vorliegenden Erfindung liegt die Aufgabe zu Grunde, ein Klemmbauteil der eingangs beschriebenen Art derart zu verbessern, dass eine Montage auch unter beengten Bedingungen möglich ist und die erforderliche Andruckkraft variabel einstellbar ist.

Erfindungsgemäß wird dies dadurch erreicht, dass das Klemmbauteil einen Gehäuserahmen aufweist, und mindestens eine von seinen Rahmenwandungen umschlossene Aufnahmekammer für den Kühlflansch und das mit dem Kühlflansch zu kontaktierende Leistungs-Bauelement, wobei zwischen einer Rahmenwandung und dem dieser gegenüberliegenden Leistungs-Bauelement oder dem dieser gegenüberliegenden Kühlflansch ein Andruckelement angeordnet ist, sowie zwischen dem Andruckelement und der Rahmenwandung ein Trennungsspalt vorhanden ist, in den ein Spreizelement einseitig kraft- und/oder formschlüssig derart einbringbar ist, dass das Leistungs-Bauelement an den Kühlflansch angepresst wird. Das erfindungsgemäße Klemmbauteil kann somit von oben über den Kühlflansch und den diesem zugeordneten Bauelement aufgesteckt werden, so dass auch bei beengten Platzverhältnissen eine einfache Montage möglich ist, da es nicht erforderlich ist, dass ein seitlicher Montageraum vorhanden ist. Indem das Spreizelement ebenfalls von oben in das Klemmbauteil eingeführt wird, wird mittels des erfindungsgemäßen Klemmbauteils die beim Anbringen des Spreizelementes aufzubringende parallel zum Leistungs-Bauelement verlaufende Kraft in eine senkrecht zum Leistungs- Bauelement bzw. Kühlflansch verlaufende Kraft umgewandelt Somit ist ein leichtes und schnelles Fügen, ohne vordefinierte Kräfte überwinden zu müssen, möglich. Zudem wird beim Montieren des erfindungsgemäßen Klemmbauteils kein Druck auf das Leistungs-Bauelement, dessen Lötverbindung und die Leiterplatte ausgeübt.

Erfindungsgemäß ist es hierbei vorteilhaft, wenn die Aufnahmekammer eine untere Aufstecköffnung aufweist und das Andruckelement im Bereich der Aufstecköffnung mit der Rahmenwandung flexibel, insbesondere über ein Filmscharnier verbunden ist. Hierdurch ist es möglich, das Andruckelement einstückig mit dem Klemmbauteil herzustellen, und das Andruckelement ist nach der Montage ausgerichtet in Bezug auf den Kühlflansch und das Leistungs-Bauelement.

Weiterhin ist es zweckmäßig, wenn das Spreizelement aus einer in einen Gewindekanal einschraubbaren Spreizschraube besteht. Über das Anzugsmoment der Spreizschraube ist es möglich, eine definierte Anpresskraft einzustellen und durch das Einschrauben von oben in den Gewindekanal, der parallel zur Kühlfläche des Kühlflansches verläuft, wird die senkrechte Kraft in eine waagerechte Anspresskraft umgewandtelt.

Weiterhin bezieht sich die Erfindung auf ein Elektronikgehäuse, insbesondere für Elektromotoren, wobei mittels des erfindungsgemäßen Klemmbauteils die vorhandenen Leistungs- Bauelemente mit dem Kühlflansch wärmeleitend verbunden sind.

Vorteilhafte Ausbildungen der Erfindung sind in den Unteransprüchen enthalten. Die Erfindung wird an Hand der in den beiliegenden Zeichnungen dargestellten Ausführungsbeispiele näher erläutert, wobei gleiche Teile mit jeweils denselben Bezugsziffern gekennzeichnet sind.

Es zeigen:
- Fig. 1: eine Ansicht eines Statorflansches mit zugehörigen elektronischer Schaltung für einen Elektromotor unter Verwendung erfindungsgemäßer Klemmbauteile,
- Fig. 2: einen Schnitt entlang der Schnittlinie II-II in Fig. 1, einer ersten erfindungsgemäßen Ausführungsform,
- Fig. 3: eine perspektivische Oberansicht eines erfindungsgemäßen Klemmbauteils gemäß Fig. 2,
- Fig. 4: eine perspektivische Unteransicht auf das Klemmbauteil gemäß Fig. 3,
- Fig. 5: einen Schnitt entlang der Schnittlinie V-V in Fig. 1, einer zweiten erfindungsgemäßen Ausführungsform,
- Fig. 6: eine perspektivische Oberansicht des erfindungsgemäßen zweiten Klemmbauteils gemäß Fig. 5 und
- Fig. 7: eine perspektivische Unteransicht auf das zweite Klemmbauteil gemäß Fig. 6.

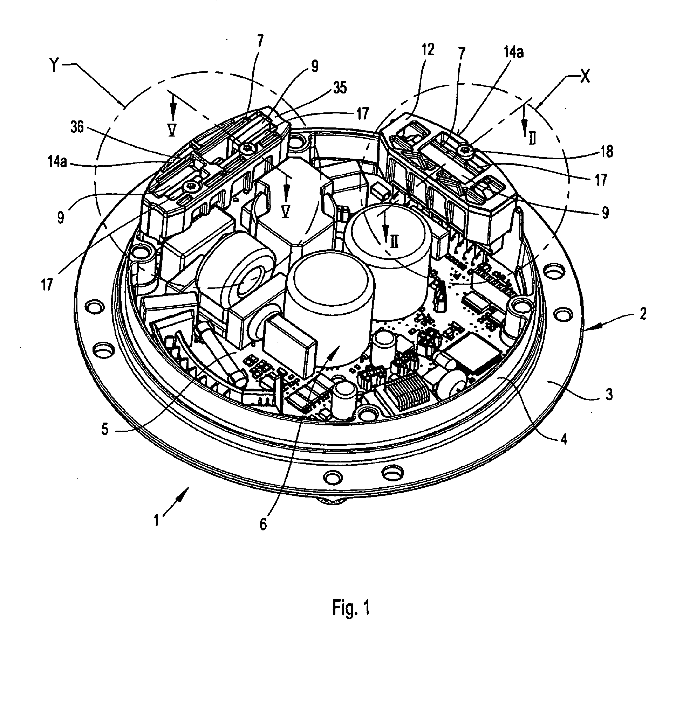

In Fig. 1 ist eine Teilansicht eines Stators 1 dargestellt, der Teil eines Elektromotors ist, der einen endseitigen ringförmigen Statorflansch 2 besitzt. Der Stator 1 und der Statorflansch 2 sind z. B. als Aluminium-Druckgussteile gefertigt. Der Statorflansch 2 besitzt einen Montagerand 3 und zu diesem konzentrisch nach innen versetzt einen senkrecht abstehenden Auflagesteg 4. In einem von dem Auflagesteg 4 umfassten Innenraum ist eine z. B. kreisförmige Leiterplatte 5 mit einer Elektronikschaltung 6 befestigt. Auf den Auflagesteg 4 kann ein nicht dargestellter Deckel aufgesetzt werden. An dem Statorflansch 2 ist mindestens ein Kühlflansch 7, im dargestellten Ausführungsbeispiel sind es zwei Kühlflansche 7, einstückig angeformt, die senkrecht zur Oberfläche des Montagerandes 3 des Statorflansches 2 abstehen und über den Auflagesteg 4 hinausragen.

Auf der Leiterplatte 5 sind Leistungs-Bauteile, wie z. B. Leistungs-Halbleiter 9 über Lötstifte 10 befestigt. Hierbei ist die Anordnung der Leistungs- Bauelemente 9 derart, dass sie parallel zu einer Anlagefläche 11 der Kühlflansche 7 mit ihren Oberflächen verlaufen und im montierten Zustand der Leistungs- Bauelemente 9 liegen diese an der Anlagefläche 11 in der Regel noch nicht an, sondern verlaufen mit einem sehr geringen Abstand zu dieser.

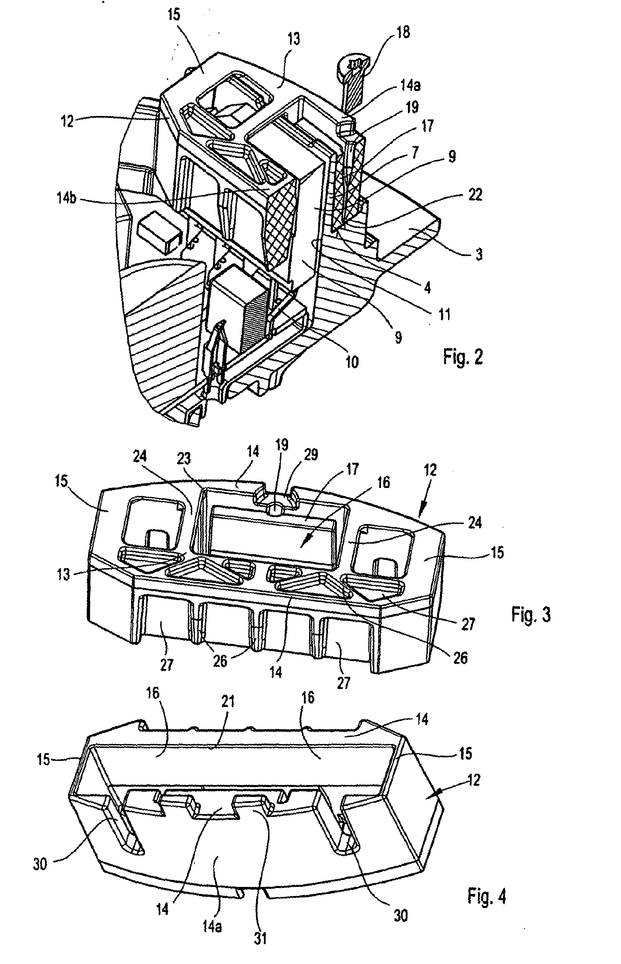

Erfindungsgemäß werden die Leistungs- Bauelemente 9 mit Klemmbauteilen 12 unter Zwischenlage einer in den Zeichnungen nicht dargestellten isolierenden Wärmeleitfolie (Wärmeleit-Pad) an die Anlagefläche 11 des Kühlflansches 7 angedrückt, um einen guten Wärmeübergang zu dem Kühlflansch 7 zu gewährleisten. Diese Klemmbauteile 12 bestehen aus einem Gehäuserahmen 13 mit mindestens einer von seinen Rahmenwandungen 14, 15 umschlossenen Aufnahmekammer 16, wie dies für ein erstes Ausführungsbeispiel in den Fig. 1 bis 4 dargestellt ist. In der Aufnahmekammer 16 werden das Leistungs- Bauelement 9 und der Kühlflansch 7 formschlüssig aufgenommen, wobei die Aufnahmekammer 16 an die Abmessungen des Leistungs-Bauelementes 9 und des Kühlflansches 7 angepasst ist. Zwischen einer der Rahmenwandungen 14 und dem dieser gegenüberliegenden Kühlflansch 7 ist ein Andruckelement 17 vorgesehen. Wie aus Fig. 2 ersichtlich ist, befindet sich in dem vorliegenden Ausführungsbeispiel das Andruckelement 17 zwischen der äußeren Rahmenwandung 14a und dem Kühlflansch 7. Weiterhin ist ein Spreizelement vorhanden, das im dargestellten Ausführungsbeispiel als Spreizschraube 18 ausgeführt ist, die in einem zwischen der Rahmenwandung 14a und dem Andruckelement 17 ausgebildeten Schraubkanal 19 in Richtung auf eine_untere Aufstecköffnung 21 der Aufnahmekammer 16 parallel zum Andruckelement 17 verlaufend einschraubbar ist. Das Andruckelemente 17 ist im Bereich der Aufstecköffnung 21 mit der Rahmenwandung 14a flexibel, insbesondere durch ein Filmscharnier 22 einstückig verbunden.

Das Klemmbauteil 12 ist aus wärmestabilem Kunststoff, z. B. Polyamid, insbesondere als Spritzgussteil ausgeführt. Um dem Klemmbauteil 12 eine ausreichende Steifigkeit zu geben, weist dieses an einer oberen Öffnung 23 der Aufnahmekammer 16 Versteifungsstege 24 auf, die parallel zu den Rahmenwandungen 15 verlaufen. Zusätzlich können auch die oberen Endflächen der Rahmenwandungen 15 stegartig verbreitert sein, so dass hierdurch eine zusätzliche Versteifung erreicht wird. Die Wanddicke der Rahmenwandungen 14, 15 ist derart bemessen, dass eine ausreichende bzw. optimale Formstabilität und Festigkeit des Klemmbauteils 12 gewährleistet ist, wobei durch Verrippungen 26 in Verbindung mit Materialausnehmungen 27 einerseits Herstellungsmaterial eingespart, andererseits aber die notwendige Festigkeit sichergestellt wird.

Das erfindungsgemäße Klemmbauteil 12 wird mit seiner Aufstecköffnung 21 von oben über den Kühlflansch 7 und dem diesem zugeordneten Leistungs-Bauelement 9 gesteckt, bis das Klemmbauteil 12 an dem Auflagesteg 4 mit seiner äußeren Rahmenwandung 14a anliegt. Zweckmäßigerweise ist die äußere Rahmenwandung 14a an ihrer Außenseite bogenförmig geformt, und zwar in Anpassung an den Verlauf des Auflagesteges 4. In der aufgesteckten Stellung befindet sich das Andruckelement 17 zwischen der äußeren Rahmenwandung 14a und dem Kühlflansch 7. Indem die Spreizschraube 18 in den Schraubkanal 19 eingeschraubt wird, wird der Abstand zwischen dem Andruckelement 17 und der Rahmenwandung 14a vergrößert. Hierdurch werden einerseits Abstandsspalte zwischen dem Andruckelement 17 und dem Kühlflansch 7 beseitigt und andererseits auch die Trennspalte zwischen der Vorderseite der Leistungs-Bauelemente 9 und der Rahmenwandung 14b sowie zwischen der Rückseite des Leistungs-Bauelementes 9 und dem Kühlflansch 7. Das Leistungs-Bauelement 9 wird hierdurch unter Zwischenlage eines in den Zeichnungen nicht dargestellten Wärmeleitelementes (Wärmeleit-Pad) an den Kühlflansch 7 gepresst, so dass eine optimale Wärmeübertragung zwischen beiden Teilen erfolgen kann.

Der Vorteil des erfindungsgemäßen Klemmbauteils 12 besteht darin, dass dieses von oben auf den Kühlflansch 7 und das Leistungs- Bauelement 9 aufgesteckt und auch das Spreizelement, und zwar die Spreizschraube 18 des vorliegenden Ausführungsbeispiels von oben her eingeführt und betätigt werden kann, so dass auch bei beengten Platzverhältnissen eine leichte Handhabung möglich ist. Zudem wird durch die Montage und den Klemmvorgang die Lötverbindung zwischen dem Leistungs-Bauelement 9 und der Leiterplatte 5 nicht nachteilig belastet. Durch das jeweilige Anzugsmoment der Spreizschraube 18 kann eine Einstellung der Klemmkraft erfolgen. Damit die Spreizschraube 18 mit ihrem Schraubenkopf nicht störend vorsteht, ist die Schraube derart bemessen, dass sie im eingeschraubten Zustand in der Oberseite mit ihrem Schraubenkopf versenkt ist, wofür in der Oberseite des Klemmbauteils 12 an den Schraubenkopf angepasste Ausnehmungen 29 ausgeformt sind.

In Fig. 4 ist die Unterseite eines erfindungsgemäßen Klemmbauteils 12 dargestellt, woraus zu erkennen ist, dass in der äußeren Rahmenwandung 14a jeweils vor den Wandungsenden offene Schlitze 30 ausgespart sind, in die Fortsätze des Auflagesteges aufgenommen werden können, wodurch eine Formschlussverbindung mit dem Statorflansch 2 erreicht wird. Beabstandete Fortsätze 31 am äußeren Rand der unteren Auflagefläche der äußeren Rahmenwandung 14a dienen ebenfalls zur Positionierung.

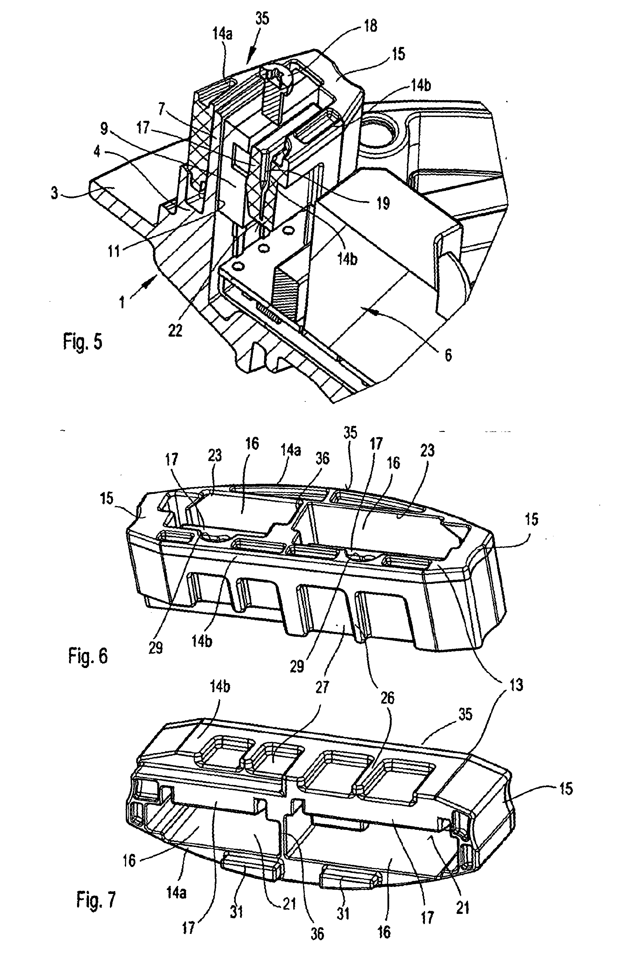

In Fig. 1 bei Y und in den Fig. 5 bis 7 ist eine zweite Ausführungsform eines erfindungsgemäßen Klemmbauteils 35 dargestellt. Hierbei sind gleiche bzw. funktionsgleiche Teile wie in den Fig. 2 bis 5 mit denselben Bezugsziffern gekennzeichnet. Das Klemmbauteil 35 besitzt zwei nebeneinander liegende Aufnahmekammern 16, die durch eine Querwand 36 voneinander getrennt sind. Jede der Aufnahmekammern 16 dient zur Aufnahme eines Leistungs- Bauelementes 9 und einem diesem zugeordneten Kühlflansch 7, so dass diese erfindungsgemäße Ausführungsform des Klemmbauteils 35 zwei Leistungs- Bauelemente 9 an ihrem jeweiligen Kühlflansch 7 gleichzeitig fixieren kann. Bei dieser Ausführungsform ist das Andruckelement 17 zwischen der inneren Rahmenwandung 14b und dem Leistungs-Halbleiter 9 angeordnet. Durch Einschrauben der Spreizschrauben 18 in die Schraubenkanäle 19 wird der Abstand zwischen der inneren Rahmenwandung 14b und dem lageveränderbaren Andruckelement 17 vergrößert und somit werden die Leistungs-Halbleiter 9 ebenfalls unter Zwischenlage eines isolierenden Wärmeleitelementes an die Kühlflansche 7 gedrückt und gleichzeitig auch die äußere Rahmenwandung 14a an die Kühlflansche 7.

Im Übrigen sind die erfindungsgemäßen Klemmbauteile 12 und 35 in ihrer Außenkontur derart ausgestaltet, dass sie sich in optimaler Weise an die jeweiligen Einbauverhältnisse anpassen. Vorteilhafterweise werden die Klemmbauteile 12 und 35 als Spritzgussformteile aus Kunststoff hergestellt.

Die vorliegende Erfindung ist nicht auf die dargestellten Ausführungsbeispiele beschränkt, sondern umfasst auch alle im Sinne der Erfindung gleichwirkenden Mittel. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmalen definiert sein. Dies bedeutet, dass grundsätzlich praktisch jedes Einzelmerkmal des Anspruchs 1 weggelassen bzw. durch mindestens ein an anderer Stelle der Anmeldung offenbartes Einzelmerkmal ersetzt werden kann. Insofern ist der Anspruch 1 lediglich als ein erster Formulierungsversuch für eine Erfindung zu verstehen.

## Patentansprüche

1. Klemmbauteil zum Andrücken von Leistungs- Bauelementen (9) an Kühlflächen von Kühlflanschen (7) eines Gehäuses, insbesondere zur Aufnahme einer Elektronikschaltung,
**gekennzeichnet durch** einen Gehäuserahmen (13) mit mindestens einer von seinen Rahmenwandungen (14a, 14b, 15) umschlossenen Aufnahmekammer (16) für den Kühlflansch (7) und das mit dem Kühlflansch (7) zu kontaktierende Leistungs-Bauelement (9), wobei zwischen einer Rahmenwandung (14a, 14b) und dem dieser gegenüberliegenden Leistungs-Bauelement (9) oder dem dieser gegenüberliegenden Kühlflansch (7) ein Andruckelement (17) angeordnet ist, sowie zwischen dem Andruckelement (17) und der Rahmenwandung (14a, 14b) ein Trennungsspalt vorhanden ist, in den ein Spreizelement (18) einseitig kraft- und/oder formschlüssig derart einbringbar ist, dass das Leistungs- Bauelement (9) an den Kühlflansch (7) angepresst wird.

2. Klemmbauteil nach Anspruch 1,
**dadurch gekennzeichnet, dass** dieAufnahmekammer(16)eine untere Aufstecköffnung (21) aufweist, und das Andruckelement (17) im Bereich der Aufstecköffnung (21) mit der Rahmenwandung (14a, 14b) flexibel verbunden ist.

3. Klemmbauteil nach Anspruch 2,
**dadurch gekennzeichnet, dass** zur flexiblen Verbindung ein Filmscharnier zwischen der Rahmenwandung (14a, 14b) und dem Andruckelement (17) ausgebildet ist.

4. Klemmbauteil nach einem der Ansprüche 1 bis 3,
**dadurch gekennzeichnet, dass** dasSpreizelement(18)in Richtung auf die Aufstecköffnung (21) parallel zum Andruckelement (17) verlaufend einbringbar ist.

5. Klemmbauteil nach Anspruch 4,
**dadurch gekennzeichnet, dass** das Spreizelement au seiner in einen Gewindekanal (19) einschraubbaren Spreizschraube (18) besteht.

6. Klemmbauteil nach einem der Ansprüche 1 bis 5,
**dadurch gekennzeichnet, dass** zwei Aufnahmekammern (16) mit jeweils einem zugehörigen Andruckelement (17) getrennt nebeneinander ausgebildet sind.

7. Klemmbauteil nach einem der Ansprüche 1 bis 6,
**dadurch gekennzeichnet, dass** der Gehäuserahmen (13) und die jeweiligen Andruckelemente (17) aus einem wärmestabilen Kunststoff, insbesondere Polyamid bestehen.

8. Klemmbauteil nach einem der Ansprüche 1 bis 7,
**dadurch gekennzeichnet, dass** derGehäuserahmen(13)und die jeweiligen Andruckelemente (17) als einstückiges Spritzgussteil ausgebildet sind.

9. Klemmbauteil nach einem der Ansprüche 1 bis 8,
**dadurch gekennzeichnet, dass** an einer oberen Öffnung (23) der Aufnahmekammer (16) Versteifungsstege (24) ausgebildet sind, die parallel zu den Rahmenwandungen (15) verlaufen.

10. Klemmbauteil nach einem der Ansprüche 1 bis 9,
**dadurch gekennzeichnet, dass** auf einer oberen Endfläche der Rahmenwandung (15) stegartige Verbreiterungen ausgebildet sind, die zur Versteifung dienen.

11. Klemmbauteil nach einem der Ansprüche 1 bis 10,
**dadurch gekennzeichnet, dass** die Rahmenwandungen (14a, 14b, 15) derart bemessen sind, dass eine ausreichende Formstabilität und Festigkeit gewährleistet ist, wobei durch Verrippungen (26) in Verbindung mit Materialausnehmungen (27) Herstellungsmaterial eingespart und die notwendige Festigkeit sichergestellt wird.

12. Elektronikgehäuse für Elektromotoren mit einem Gehäuseboden, der von einem Statorflansch (2) aus Metall eines Stators (1) gebildet wird, wobei an dem Gehäuseboden mindestens ein vorstehender Kühlflansch (7) angeformt ist,
**dadurch gekennzeichnet, dass** mittels eines Klemmbauteils (12, 35) nach einem der Ansprüche 1 bis 11 an dem Kühlflansch (7) ein Leistungs-Bauelement (9) unter Anlagedruck klemmend fixiert ist.

## Claims

1. A clamp component for pressing high performance components (9) against cooling surfaces of cooling flanges (7) of a housing, in particular for receiving an electronic circuit,
**characterised by** a housing frame (13) having at least one receiving chamber (16) for the cooling flange (7) and the high performance component (9) which is to be brought into contact with the cooling flange (7), wherein the receiving chamber (16) is surrounded by the frame walls (14a, 14b, 15) of the housing frame (13), wherein there is arranged between a frame wall (14a, 14b) and the high performance component (9) opposite it, or the cooling flange (7) opposite it, a contact pressure element (17), and wherein there is between the contact pressure element (17) and the frame wall (14a, 14b) a dividing gap into which an expansion element (18) may be introduced in force-locked and/or form-locked manner on one side such that the high performance component (9) is pressed against the cooling flange (7).

2. A clamp component according to Claim 1, **characterised in that** the receiving chamber (16) includes a lower push-on opening (21), and the contact pressure element (17) is flexibly connected to the frame wall (14a, 14b) in the region of the push-on opening (21).

3. A clamp component according to Claim 2, **characterised in that**, for flexible connection, a film hinge is formed between the frame wall (14a, 14b) and the contact pressure element (17).

4. A clamp component according to one of Claims 1 to 3, **characterised in that** the expansion element (18) may be introduced in a manner extending parallel to the contact pressure element (17), in the direction of the push-on opening (21).

5. A clamp component according to Claim 4, **characterised in that** the expansion element comprises an expansion screw (18) which may be screwed into a threaded channel (19).

6. A clamp component according to one of Claims 1 to 5, **characterised in that** two receiving chambers (16) are formed separately next to one another, each having an associated contact pressure element (17).

7. A clamp component according to one of Claims 1 to 6, **characterised in that** the housing frame (13) and the respective contact pressure elements (17) are made from a heat-stable synthetic material, in particular polyamide.

8. A clamp component according to one of Claims 1 to 7, **characterised in that** the housing frame (13) and the respective contact pressure elements (17) take the form of a one-piece injection moulded part.

9. A clamp component according to one of Claims 1 to 8, **characterised in that** reinforcing ribs (24) are formed on an upper opening (23) of the receiving chamber (16) and extend parallel to the frame walls (15).

10. A clamp component according to one of Claims 1 to 9, **characterised in that** web-like widened portions are formed on an upper end surface of the frame wall (15) and serve for reinforcement.

11. A clamp component according to one of Claims 1 to 10, **characterised in that** the frame walls (14a, 14b, 15) are dimensioned such that sufficient dimensional stability and strength are ensured, wherein ribs (26) in conjunction with material cutouts (27) have the effect that manufacturing material is saved and the required strength is ensured.

12. An electronic housing for electric motors, having a housing base which is formed by a stator flange (2), made of metal, of a stator (1), wherein at least one cooling flange (7) is integrally formed on the housing base, **characterised in that** a high performance component (9) is fixed in clamping manner with abutment pressure to the cooling flange (7) by means of a clamp component (12, 35) according to one of Claims 1 to 11.

## Revendications

1. Élément de serrage pour fixer par serrage des composants de puissance (9) sur des surfaces de refroidissement de brides de refroidissement (7) d'un boîtier destiné en particulier à recevoir un circuit électronique,
**caractérisé par** un cadre (13) du boîtier, comportant au moins une chambre de réception (16), entourée par les parois (14a, 14b, 15) du cadre, pour la bride de refroidissement (7) et le composant de puissance (9) à mettre en contact avec la bride de refroidissement (7), dans lequel un élément de pression (17) est disposé entre une paroi (14a, 14b) du cadre et le composant de puissance (9) lui faisant face ou la bride de refroidissement (7) lui faisant face, et entre l'élément de pression (17) et la paroi (14a, 14b) du cadre existe une fente de séparation, dans laquelle un élément écarteur (18) peut être inséré sur un côté par force et/ou par conjugaison de forme, de telle sorte que le composant de puissance (9) est pressé contre la bride de refroidissement (7).

2. Élément de serrage selon la revendication 1, **caractérisé en ce que** la chambre de réception (16) comporte une ouverture d'enfichage (21), et l'élément de pression (17) est relié de manière flexible à la paroi (14a, 14b) du cadre dans la zone de l'ouverture d'enfichage (21).

3. Élément de serrage selon la revendication 2, **caractérisé en ce que** pour l'assemblage flexible, une charnière flexible est réalisée entre la paroi (14a, 14b) du cadre et l'élément de pression (17).

4. Élément de serrage selon l'une quelconque des revendications 1 à 3, **caractérisé en ce que** l'élément écarteur (18) peut être introduit en s'étendant vers l'ouverture d'enfichage (21) parallèlement à l'élément de pression (17).

5. Élément de serrage selon la revendication 4, **caractérisé en ce que** l'élément écarteur est formé par une vis d'écartement (18) pouvant être vissée dans un conduit fileté (19).

6. Élément de serrage selon l'une quelconque des revendications 1 à 5, **caractérisé en ce que** deux chambres de réception (16), munie chacune d'un élément de pression (17) associé, sont réalisées séparément l'une à côté de l'autre.

7. Élément de serrage selon l'une quelconque des revendications 1 à 6, **caractérisé en ce que** le cadre (13) du boîtier et les éléments de pression (17) respectifs sont réalisés dans une matière plastique résistant à la chaleur, en particulier un polyamide.

8. Élément de serrage selon l'une quelconque des revendications 1 à 7, **caractérisé en ce que** le cadre (13) du boîtier et les éléments de pression (17) respectifs sont réalisés sous la forme d'une pièce d'un seul tenant moulée par injection.

9. Élément de serrage selon l'une quelconque des revendications 1 à 8, **caractérisé en ce qu'**au niveau d'une ouverture (23) supérieure de la chambre de réception (16) sont réalisées des nervures de renforcement (24) qui sont parallèles aux parois (15) du cadre.

10. Élément de serrage selon l'une quelconque des revendications 1 à 9, **caractérisé en ce que** sur une surface d'extrémité supérieure de la paroi (15) du cadre sont réalisés des élargissements en forme d'ailettes qui sont destinées à rigidifier.

11. Élément de serrage selon l'une quelconque des revendications 1 à 10, **caractérisé en ce que** les parois (14a, 14b, 15) du cadre sont dimensionnées de manière à garantir une stabilité de forme et une résistance suffisantes, les nervures (26) en association avec des évidements de matière (27) permettant d'économiser le matériau de fabrication et de garantir la résistance nécessaire.

12. Boîtier électronique pour des moteurs électriques, comportant un fond qui est formé par une collerette (2) en métal d'un stator (1), au moins une bride de refroidissement (7) saillante étant formée sur le fond du boîtier,
**caractérisé en ce qu'**au moyen d'un élément de serrage (12, 35) selon l'une quelconque des revendications 1 à 11, un composant de puissance (9) est fixé par serrage sur la bride de refroidissement (7) moyennant l'application d'une pression.
